# EUROPÄISCHE PATENTANMELDUNG

(11) **EP 0 900 621 A2**
(43) Veröffentlichungstag der Anmeldung: **10.03.1999**
(21) Anmeldenummer: 98115668.0
(22) Anmeldetag: 20.08.1998
(51) Int. Cl.: B23K 9/32, H05K 7/20

(54) **Stromversorgungseinheit**

(30) Priorität: 08.09.1997 DE 19739309
(71) Anmelder: Lorch Schweisstechnik GmbH, 71549 Auenwald (DE)
(72) Erfinder: Jaeschke, Birger, 71522 Backnang (DE); Dieterich, Hans-Joachim, 71397 Leutenbach (DE)
(74) Vertreter: Hoeger, Stellrecht & Partner

(57) **Zusammenfassung**

Um eine Stromversorgungseinheit für Schweißgeräte, umfassend ein Außengehäuse, welches einen Schaltungsraum umgibt, in welchem elektrische Bauteile einer Stromversorgungsschaltung angeordnet sind, und einen Kühlkörper mit von einem zwangsbewegten Luftstrom angeströmten Kühlrippen, welche Abwärme von wärmeentwickelnden elektrischen Bauteilen der Stromversorgungsschaltung an den zwangsbewegten Luftstrom abgeben, derart zu verbessern, daß deren Staubanfälligkeit verringert wird, wird vorgeschlagen, daß das Außengehäuse neben dem Schaltungsraum ein von diesem getrennten Kühlraum umgibt, daß die Kühlrippen des Kühlkörpers in dem Kühlraum angeordnet sind und daß das Außengehäuse mindestens eine Seitenwand des Kühlraums bildet.

## Beschreibung

Die Erfindung betrifft eine Stromversorgungseinheit für Schweißgeräte, umfassend ein Außengehäuse, welches einen Schaltungsraum umgibt, in welchem elektrische Bauteile einer Stromversorgungsschaltung angeordnet sind, und einen Kühlkörper mit von einem zwangsbewegten Luftstrom angeströmten Kühlrippen, welche Abwärme von wärmeentwickelnden elektrischen Bauteilen der Stromversorgungsschaltung an den zwangsbewegten Luftstrom abgeben.

Derartige Stromversorgungseinheiten sind aus dem Stand der Technik bekannt. Bei diesen ist üblicherweise innerhalb des Außengehäuses ein Raum vorgesehen, in welchem sämtliche elektrische Bauteile und auch die wärmeentwickelnden elektrischen Bauteile mitsamt den Kühlkörpern vorgesehen sind. Um diese zu kühlen, wird der zwangsbewegte Luftstrom durch den Schaltungsraum geführt.

Da die Stromversorgungseinheiten von Schweißgeräten vielfach unter Umgebungsbedingungen mit hoher Luftverschmutzung, insbesondere Staubverschmutzung, eingesetzt werden, entstehen ständig dadurch Probleme, daß die Kühlrippen von Staub zugesetzt werden. Ist der Staub dann noch Metallstaub, welcher beispielsweise heim Schleifen anfällt, so ist der Staub auch elektrisch leitfähig und hat dann, wenn er sich an den elektrischen Bauteilen ansetzt, vielfach Kriechströme zur Folge.

Der Erfindung liegt daher die Aufgabe zugrunde, eine Stromversorgungseinheit der gattungsgemäßen Art derart zu verbessern, daß deren Staubanfälligkeit verringert wird.

Diese Aufgabe wird bei einer Stromversorgungseinheit der eingangs beschriebenen Art erfindungsgemäß dadurch gelöst, daß das Außengehäuse neben dem Schaltungsraum einen von diesem getrennten Kühlraum umgibt, daß die Kühlrippen des Kühlkörpers in dem Kühlraum angeordnet sind und daß das Außengehäuse mindestens eine Seitenwand des Kühlraums bildet.

Der Vorteil der erfindungsgemäßen Lösung ist darin zu sehen, daß durch die Trennung von Schaltungsraum und Kühlraum nunmehr nicht mehr die Gefahr besteht, daß die elektrischen Bauteile mit Staub in Berührung kommen und sich somit Kriechströme entwickeln.

Darüber hinaus hat die Trennung von Schaltungsraum und Kühlraum noch zusätzlich den Vorteil, daß damit problemlos eine hohe Kühlleistung erreicht werden kann, da bei der Führung des den Kühlkörper beaufschlagenden Luftstroms keinerlei Rücksicht mehr auf die elektrischen Bauteile im Schaltungsraum genommen werden muß.

Eine besonders günstige Lösung sieht dabei vor, daß das Außengehäuse in seinem die Seitenwand des Kühlraums bildenden Bereich eine mit einer lösbaren Abdeckung verschließbare Reinigungsöffnung aufweist, durch welche der Kühlraum zugänglich ist.

Das Vorsehen einer Reinigungsöffnung hat nun zusätzlich den großen Vorteil, daß der Benutzer die Möglichkeit hat, den Kühlraum zu reinigen, beispielsweise auszusaugen oder auszublasen, und somit den Staub zu entfernen, um die Kühlwirkung des Kühlkörpers wieder zu steigern, ohne daß - wie aus dem Stand der Technik bekannt - das gesamte Außengehäuse entfernt werden muß.

Besonders günstig ist es dabei, wenn der Schaltungsraum durch die Reinigungsöffnung unzugänglich angeordnet ist, so daß jederzeit für den Benutzer ein Zugang zum Kühlraum möglich gemacht werden kann, da dieser keinerlei Gefahr läuft, mit den elektrischen Bauteilen in Berührung zu kommen und dadurch Schaden zu erleiden.

Übrigens ist besonders günstig, wenn die Reinigungsöffnung außerhalb von an den Schaltungsraum angrenzenden Bereichen des Außengehäuses angeordnet ist, so daß durch die Reinigungsöffnung ein unmittelbarer und erleichterter Zugang zu dem Kühlraum geschaffen werden kann.

Im Zusammenhang mit der bisherigen Erläuterung der einzelnen Ausführungsbeispiele wurde nicht darauf eingegangen, wie der zwangsbewegte Luftstrom aus dem Kühlraum austreten soll. Vorzugsweise ist hierzu vorgesehen, daß das Außengehäuse in den Seitenwände des Kühlraums bildenden Bereichen Auslaßöffnungen für einen Abluftstrom aus dem Kühlraum vorsieht.

Eine besonders günstige Lösung sieht vor, daß die lösbare Abdeckung der Reinigungsöffnung mit Auslaßöffnungen für den Abluftstrom versehen ist, da in diesem Fall die Möglichkeit besteht, die Reinigungsöffnungen so anzuordnen, daß durch diese auch der Abluftstrom austritt, so daß nach Entfernen der lösbaren Abdeckung ein besonders günstiger Zugriff auf den Kühlkörper zur Reinigung desselben möglich ist.

Eine besonders zweckmäßige Lösung sieht vor, daß das Außengehäuse mindestens zwei Seitenwände des Kühlraums bildet, so daß der Kühlraum innerhalb des Außengehäuses in unmittelbarem Anschluß an diese zwei Seitenwände liegt, und somit auch zur Reinigung besonders günstig zugänglich gemacht werden kann.

Noch besser ist es, wenn das Außengehäuse mindestens drei Seitenwände des Kühlraums bildet, so daß insbesondere eine Zufuhr des Luftstroms sowie die Führung des Abluftstroms in einfacher Weise realisierbar ist.

In diesen Fällen sieht eine hinsichtlich der Reinigung besonders günstige Möglichkeit vor, daß das Außengehäuse zwei einander gegenüberliegende Reinigungsöffnungen aufweist. Damit ist die Möglichkeit gegeben, in vorteilhafter Weise, nämlich von zwei einander gegenüberliegenden Seiten, auf den Kühlkörper zuzugreifen und diesen somit besonders vorteilhaft zu reinigen. Ferner ist auch die Führung des Abluftstroms günstig, da nämlich dann die Möglichkeit besteht, den Abluftstrom in zwei einander entgegengesetzten Richtungen abzuführen.

Hinsichtlich der Anordnung des Schaltungsraums im Außengehäuse wurden bislang keine näheren Angaben gemacht. So sieht ein besonders vorteilhaftes Ausführungsbeispiel vor, wenn das Außengehäuse mindestens eine Seitenwand des Schaltungsraums, noch besser mindestens zwei Seitenwände, und besonders vorteilhaft, mindestens drei Seitenwände des Schaltungsraums bildet.

Hinsichtlich der Anordnung des Kühlraums und des Schaltungsraums, die im Außengehäuse relativ zueinander angeordnet sind, wurden bislang keine näheren Angaben gemacht.

Eine besonders günstige Raumaufteilung liegt dann vor, wenn der Kühlraum und der Schaltungsraum im Außengehäuse auf gegenüberliegenden Seiten angeordnet sind.

Dabei wäre es denkbar, den Schaltungsraum und den Kühlraum so anzuordnen, daß beispielsweise zwischen diesen noch ein zusätzlicher Raum liegt, welcher eine möglichst gute Trennung der beiden Räume noch günstiger realisieren ließe.

Da jedoch die wärmeentwickelnden Bauteile im Schaltungsraum angeordnet sind und die Wärme von diesen zu den Kühlrippen im Kühlraum geführt werden muß, ist günstigerweise vorgesehen, daS der Kühlraum und der Schaltungsraum auf gegenüberliegenden Seiten einer Trennwand angeordnet sind, so daß ein ausreichend kurzer Weg für die Wärmeleitung erforderlich ist.

Im Fall des Vorsehens einer Trennwand sieht eine aufgrund ihrer Einfachheit besonders günstige Lösung vor, daß ein vom Außengehäuse umschlossener Innenraum durch die Trennwand in den Schaltungsraum und den Kühlraum aufgeteilt ist.

Auch beim Vorsehen von nur einer Trennwand zwischen dem Kühlraum und dem Schaltungsraum ist es im Rahmen der erfindungsgemäßen Lösung zweckmäßig, wenn der Schaltungsraum und der Kühlraum hermetisch voneinander getrennt sind.

Aus diesem Grunde ist auch vorzugsweise vorgesehen, daß der Kühlraum frei von elektrischen Bauteilen der Stromversorgungsschaltung ist, also daß einerseits keinerlei staubanfällige Bauteile im Kühlraum liegen und andererseits aber auch dem Benutzer ein gefahrloser Zugang zum Kühlraum verschafft werden kann, da bei Nichtvorhandensein von Bauteilen der Stromversorgungsschaltung gar nicht die Gefahr besteht, daß ein Benutzer aufgrund des Berührens eines derartigen Bauteils zu Schaden kommen kann.

Aus Sicherheitsgründen ist es besonders vorteilhaft, wenn der Kühlraum frei von elektrischen Leitungen der Stromversorgungsschaltung ist, so daß die Gefahr, daß ein Benutzer, beispielsweise durch Reinigen des Kühlraums unter Einsatz metallischer Gegenstände, die Leitungen der Stromversorgungsschaltung beschädigt und damit selbst zu Schaden kommen kann.

Hinsichtlich der Anordnung des Kühlkörpers wurden im Zusammenhang mit den bisherigen Ausführungsbeispielen keine näheren Angaben gemacht. So wäre es beispielsweise denkbar, den Kühlkörper beliebig im Kühlraum anzuordnen. Um jedoch möglichst kurze Wege zur Wärmeleitung zwischen den wärmeentwickelnden Bauteilen und den Kühlrippen des Kühlkörpers zu haben, ist vorzugsweise vorgesehen, daß der Kühlkörper an der Trennwand an geordnet ist.

In diesem Fall ist es erforderlich, einen Wärmekontakt zwischen den wärmeentwickelnden Bauteilen im Schaltungsraum und dem Kühlkörper herzustellen. Dies wäre beispielsweise dadurch möglich, daß die wärmeentwickelnden Bauteile ihre Wärme an die Trennwand abgehen und durch die Trennwand hindurch ein Wärmeübergang auf den Kühlkörper erfolgt. Ein mehrfacher Wärmeübergang von einem Teil auf das andere ist in der Regel nachteilig und begrenzt die Wärmeleitfähigkeit. Aus diesem Grund sieht ein besonders vorteilhaftes Ausführungsbeispiel vor, daß die Trennwand einen Durchbruch aufweist und daß im Bereich des Durchbruchs der Kühlkörper einen Teil der Trennwand bildet. Damit ist die Möglichkeit gegeben, beispielsweise von Seiten des Schaltungsraums her, die Wärme direkt auf den Kühlkörper aufzubringen.

Aus diesem Grunde ist es besonders günstig, wenn die wärmeentwickelnden Bauteile in Kontakt mit einer dem Schaltungsraum zugewandten Seite des Kühlkörpers stehen.

Der Kontakt zwischen den wärmeentwickelnden Bauteilen und dem Kühlkörper kann entweder dadurch hergestellt werden, daß der Kühlkörper sich in Richtung des Schaltungsraums erstreckende Fortsätze aufweist. Eine besonders günstige und einfache Lösung sieht vor, daß die wärmeentwickelnden Bauteile auf einer dem Schaltungsraum zugewandten Seite des Kühlkörpers sitzen.

Um auch im Falle eines Durchbruchs der Trennwand eine möglichst gute Trennung zwischen Kühlraum und Schaltungsraum zu erreichen, ist vorgesehen, daß zwischen dem Kühlkörper und der Trennwand eine Abdichtung angeordnet ist.

Hinsichtlich der Ausbildung des Kühlkörpers wurden bislang keine näheren Angaben gemacht. Der Kühlkörper kann im Prinzip beliebig ausgebildet sein. Besonders vorteilhaft ist es jedoch, wenn der Kühlkörper mit einer die Kühlrippen tragenden Grundplatte versehen ist. Mit dieser Grundplatte läßt sich der Kühlkörper besonders vorteilhaft an der Trennwand montieren und eine Abdichtung zwischen Trennwand und Kühlkörper vorsehen.

In diesem Falle ist vorzugsweise vorgesehen, daß der Kühlkörper auf seiner den Kühlrippen gegenüberliegenden Seite der Grundplatte mit Anschlußelementen, für die wärmeentwickelnden Bauteile versehen ist, wobei die Anschlußelemente ein direktes Aufliegen der Bauteile auf einer dem Schaltungsraum zugewandten Rückseite der Grundplatte oder ein Anliegen an von der Grundplatte abstehenden Stegen vorsehen können.

Im Zusammenhang mit der bisherigen Erläuterung der einzelnen Ausführungsbeispiele wurde nicht näher darauf eingegangen, wie die Kühlrippen von dem Luftstrom angeströmt werden. Beispielsweise wäre denkbar, den Luftstrom so zu führen, daß dieser parallel zur Grundplatte längs der Kühlrippen strömt.

Eine besonders vorteilhafte Lösung sieht jedoch vor, daß die Kühlrippen des Kühlkörpers in einer Richtung quer zur Grundplatte vom Luftstrom angeströmt sind, so daß der Luftstrom an den Kühlrippen vorbei zunächst auf die Grundplatte trifft und dann von der Grundplatte in Richtung längs der Kühlrippen umgelenkt wird. Eine derartige Lösung ergibt einen besonders guten Wärmeübergang zwischen Kühlkörper und Luftstrom.

Beispielsweise wäre es bei dieser Losung aber noch denkbar, den Luftstrom gegenüber der Grundplatte geneigt auftreffen zu lassen, um eine nicht allzu starke Umlenkung desselben durch die Grundplatte zu erzwingen.

Besonders vorteilhaft hat es sich jedoch erwiesen, wenn der Kühlkörper mit einem frontal auf die Grundplatte gerichteten Luftstrom angeströmt ist.

Hinsichtlich der Möglichkeit, in dem Kühlraum einen zwangsbewegten Luftstrom zu erhalten, wurden bislang keine näheren Angaben gemacht. So wäre es beispielsweise denkbar, den zwangsbewegten Luftstrom durch externe Geräte oder auch Gebläse zu erzeugen. Eine zweckmäßige und auch hinsichtlich der Unabhängigkeit des Einsatzes der erfindungsgemäßen Stromversorgungseinheit günstige Lösung sieht jedoch vor, daß in dem Kühlraum ein Gebläse zur Erzeugung des zwangsbewegten Luftstroms angeordnet ist.

Ferner sieht eine vorteilhafte Weiterbildung der erfindungsgemäßen Lösung vor, daß in dem Kühlraum ein Wasserkühler für einen Kühlwasserkreislauf einer Schweißeinrichtung angeordnet ist. Diese Lösung hat den weiteren Vorteil, daß bei einer Vielzahl von Schweißeinrichtungen ein Kühlwasserkreislauf erforderlich ist und es sich damit anbietet, auch den Wasserkühler in dem Kühlraum anzuordnen, so daß auch die Kühlung desselben mit den gleichen Vorteilen verbunden ist, wie die des Kühlkörpers im Kühlraum.

Vorzugsweise ist auch bei dem Wasserkühler vorgesehen, daß dieser von einem zwangsbewegten Luftstrom angeströmt ist, wobei dieser zwangsbewegte Luftstrom beispielsweise durch dasselbe Gebläse erzeuge werden kann, wie der zwangsbewegte Luftstrom für den Kühlkörper. Besonders vorteilhaft ist es jedoch, wenn dem Wasserkühler ein eigenes Gebläse zugeordnet ist, so daß dieses beispielsweise auch entsprechend den Anforderungen der Wasserkühlung gesteuert werden kann.

Im Zusammenhang mit allen bislang beschriebenen Ausführungsbeispielen wurde lediglich von einem zwangsbewegten Luftstrom im Kühlraum gesprochen und keine näheren Angaben zu der

Belüftung des Schaltungsraums gemacht. Grundsätzlich ist bei der erfindungsgemäßen Lösung der Schaltungsraum nicht von einem zwangsbewegten Luftstrom durchsetzt. Es besteht die Möglichkeit, den Schaltungsraum so auszubilden, daß dieser im wesentlichen von keinerlei Luftstrom durchsetzt ist. Es besteht aber auch die Möglichkeit, den Schaltungsraum durch Wärmekonvektion zu kühlen. Allerdings ist vorzugsweise bei allen erfindungsgemäßen Lösungen ein zwangsbewegter Luftstrom, das heißt ein durch Geblase oder ähnliche Geräte bewegter Luftstrom, im Schaltungsraum ausgeschlossen, um die eingangs genannte Staubproblematik im Schaltungsraum gänzlich zu vermeiden.

Hinsichtlich der Wartungsfreundlichkeit der erfindungsgemäßen Stromversorgungseinheit ist es besonders vorteilhaft, wenn die gesamte Leistungselektronik mit dem Kühlkörper verbunden und als Einheit mit diesem demontierbar ist, damit eine Verbindung zwischen Kühlkörper und Leistungselektronik nicht gelöst werden muß und somit die gesamte, auch als Einheit herzustellende Baugruppe als Ganze ausgetauscht werden kann.

Besonders vorteilhaft ist der Austausch dann, wenn die mit dem Kühlkörper verbundene Leistungselektronik über den Kühlraum zusammen mit dem Kühlkörper demontierbar ist.

Weitere Merkmale und Vorteile der Erfindung sind Gegenstand der nachfolgenden Beschreibung sowie der zeichnerischen Darstellung einiger Ausführungsbeispiele in der Zeichnung zeigen:
- Figur 1:: eine perspektivische Darstellung eines ersten Ausführungsbeispiels, wobei eine Abdeckung einer Reinigungsöffnung teilweise weggebrochen dargestellt ist;

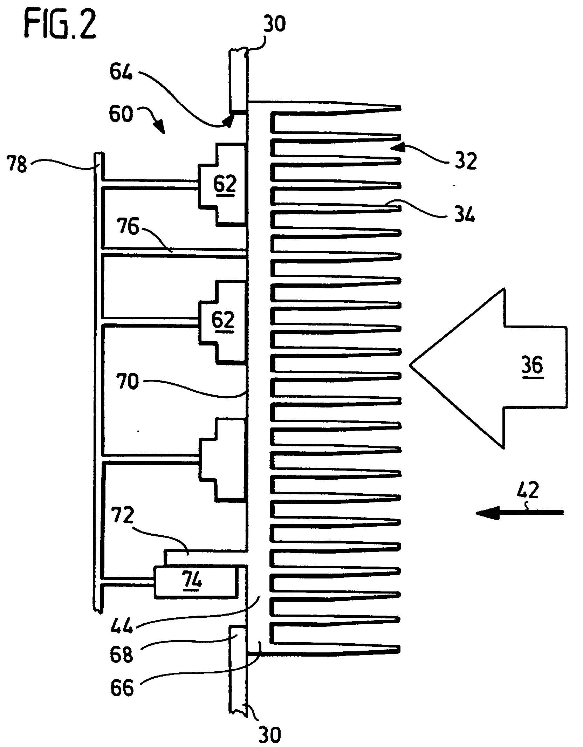

- Figur 2:: eine Seitenansicht eines zweiten Ausführungsbeispiels bei abgenommener Abdeckung für die Reinigungsöffnung; und
- Figur 3:: eine Seitenansicht eines zweiten Ausführungsbeispiels bei abgenommener Abdeckung einer Reinigungsöffnung.

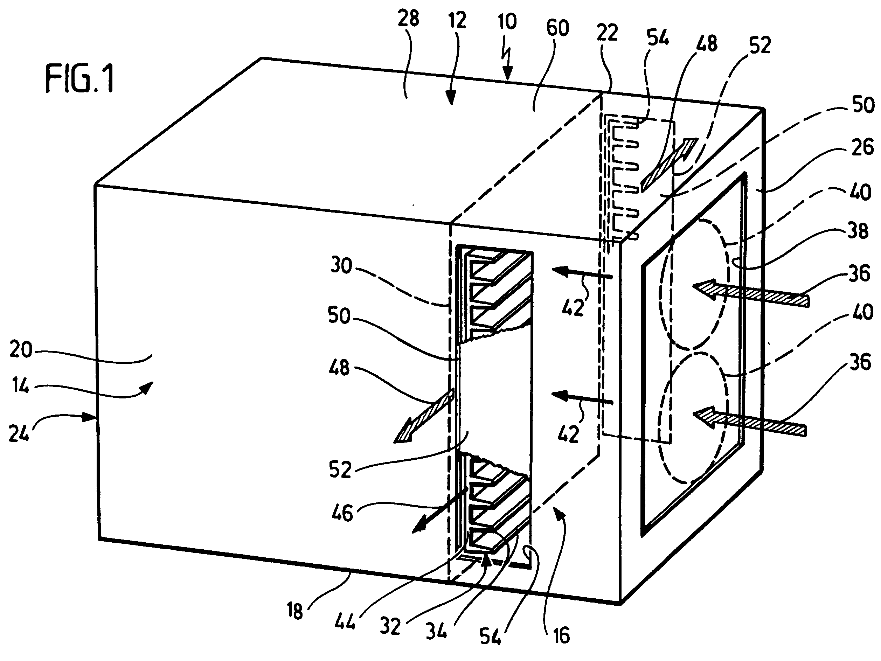

Ein erstes Ausführungsbeispiel einer erfindungsgemäßen Stromversorgungseinheit, als ganzes in Figur 1 mit 10 bezeichnet, umfaßt ein Außengehäuse 12, welches einen Schaltungsraum 14 umschließt, im welchem die elektrischen Bauteile einer Stromversorgungsschaltung der erfindungsgemäßen Stromversorgungseinheit angeordnet sind.

Ferner umgibt das Außengehäuse 12 einen Kühlraum 16, welcher gegenüber dem Schaltungsraum 14 hermetisch abgetrennt ist.

Vorzugsweise ist das Außengehäuse 12 so ausgebildet, daß es eine Bodenplatte 18, Längsseitenwände 20 und 22, eine Vorderwand 24 und eine Rückwand 26 sowie einen Deckel 28 aufweist. Da an der Vorderwand 24 üblicherweise für einen Benutzer vorgesehene Schaltelemente der Stromversorgungsschaltung angeordnet sind, umschließt vorzugsweise das Außengehäuse 12 mit der Vorderwand 24, den Seitenwänden 20 und 22 sowie dem Deckel 28 den Schaltungsraum 14, welcher jedoch nicht bis zur Rückwand 26 reicht, sondern nur bis zu einer Trennwand 30, welche parallel zur Rückwand 26, jedoch im Abstand von dieser verläuft. Die Trennwand 30 bildet dabei auch eine hermetische Abtrennung zwischen dem Schaltungsraum 14 und dem Kühlraum 16, wobei in diesem Fall der Kühlraum 16 dann von Teilen der Seitenwände 20 und 22 der Rückwand 26 und einen Teil des Deckels 28 umschlossen ist.

Die Bodenplatte 18 bildet einen unteren Abschluß sowohl für den Schaltungsraum 14 als auch den Kühlraum 16.

In dem Kühlraum 16 liegt ein Kühlkörper 32, dessen Kühlrippen 34 einem zwangsbewegten Luftstrom 36 zugewandt sind, welcher beispielsweise durch eine Eintrittsöffnung 38 in der Rückwand 26 in den Kühlraum 16 eintritt. Hinter der Eintrittsöffnung 38 liegen vorzugsweise ein Gebläse oder mehrere Gebläse 40, die für die Zwangsbewegung des Luftstroms 36 verantwortlich sind. Der Luftstrom 36 tritt mit einer Strömungsrichtung 42 in den Kühlraum 16 ein, welcher senkrecht auf einer Grundplatte 44 des Kühlkörpers 32 steht, von welcher die Kühlrippen 34 abstehen. Der Luftstrom 36 dringt dabei zwischen die Kühlrippen 34 ein und wird zwischen diesen in eine Austrittsrichtung 46 umgelenkt, welche parallel zu den Kühlrippen 34 jedoch vorzugsweise quer zur Strömungsrichtung 42 verläuft. Die Austrittsrichtung 46 verläuft im in Figur 1 dargestellten ersten Ausführungsbeispiel parallel zur Bodenplatte 18, so daß der umgelenkte Luftstrom 36 sich in der Austrittsrichtung 46 auf die beiden Seitenwände 20 und 22 in Form eines Abluftstroms 48 zubewegt, der dann durch in den Seitenwänden 20 und 22 vorgesehene Auslaßöffnungen 50 austreten kann. Die Auslaßöffnungen 50 sind dabei vorzugsweise in einer Abdeckung 52 einer Reinigungsöffnung 54 vorgesehen, die in den Kühlraum 16 umschließenden Bereichen in der Seitenwände 20, vorzugsweise zwischen der Trennwand 30 und der Rückwand 26, angeordnet ist und so groß ist, daß eine Reinigung der Kühlrippen 34 des Kühlkörpers 32 problemlos möglich ist.

Die Reinigungsöffnung 54 liegt insbesondere so, daß beim Öffnen der Abdeckung 52 ausschließlich ein Zugriff auf den Kühlraum 34 möglich ist, nicht jedoch ein Zugriff auf den Schaltungsraum 14, so daß sämtliche elektrischen Bauteile der Stromversorgungsschaltung beim Reinigen der Kühlrippen 34 nicht berührt werden können und somit das Reinigen der Kühlrippen 34 für einen Benutzer der Stromversorgungseinheit völlig ungefährlich ist.

Vorzugsweise sind die elektrischen Bauteile im Schaltungsraum so angeordnet, daß in einem sich unmittelbar an die Trennwand 30 anschließenden Teilraum 60, welcher einen Teilraum des Schaltungsraums 14 darstellt, die eine starke Wärmeentwicklung aufweisenden Bauteile 62, das heißt vorzugsweise die Leistungselektronikbauteile, angeordnet sind, um die Möglichkeit zu schaffen, die Wärme von diesen Bauteilen 62 auf möglichst kurzem Wege an den Kühlkörper 32 abzugeben.

Vorzugsweise ist hierzu die Trennwand 30 mit einem Durchbruch 64 versehen, welcher allerdings von der Grundplatte 44 des Kühlkörpers 32 überdeckt ist, wobei die Grundplatte 44 vorzugsweise mit äußeren Rändern 66 über den Durchbruch 64 übersteht und damit dichtend auf einem dem Durchbruch 64 umgebenden Randstreifen 68 der Trennwand 30 aufliegen und mit diesem abschließen kann.

Aufgrund des Durchbruchs 64 besteht nun die Möglichkeit, die eine starke Wärmeentwicklung aufweisenden Bauteile 62 unmittelbar auf eine Rückseite 70 der Grundplatte 44 aufzusetzen oder an von der Rückseite 70 abstehenden und vorzugsweise an die Grundplatte 44 angeformten Stegen 72 zu fixieren, wie dies am Beispiel des Bauteils 74 dargestellt ist.

Somit besteht die Möglichkeit, die Wärme von den Bauteilen 62 und 74 auf möglichst kurzem Wege zu den Kühlrippen 34 des Kühlkörpers 32 durch Wärmeleitung in diesem zu führen.

Vorzugsweise ist dabei die Stromversorgungsschaltung so aufgebaut, daß in dem Teilraum 60 die gesamte Leistungselektronik zu einer Einheit zusammengefaßt ist, um diese für eine Wartung leicht zugänglich zu machen. Dabei ist vorzugsweise vorgesehen, daß die Leistungselektronik, insoweit, als zusätzlich zu den Bauteilen 62 und 74 noch weitere Bauteile vorhanden sind, auf einer an dem Kühlkörper 32 mittels Haltern 76 fixierten Baugruppe 78 sitzt, so daß die gesamte Baugruppe 78 mit dem Kühlkörper 32 und den auf der Rückseite 70 oder dem Steg 72 desselben sitzenden Bauteilen 62 und 74 als Einheit demontierbar und austauschbar ist, wobei vorzugsweise eine Demontage der gesamten Leistungselektronik über den Kühlraum 16 erfolgt, nämlich dadurch, daß der Kühlkörper von der Innenwand 30 gelöst und die gesamte mit diesem zusammenhängende Leistungselektronik aus dem Teilraum 60 des Schaltungsraums 14 entnehmbar und austauschbar ist.

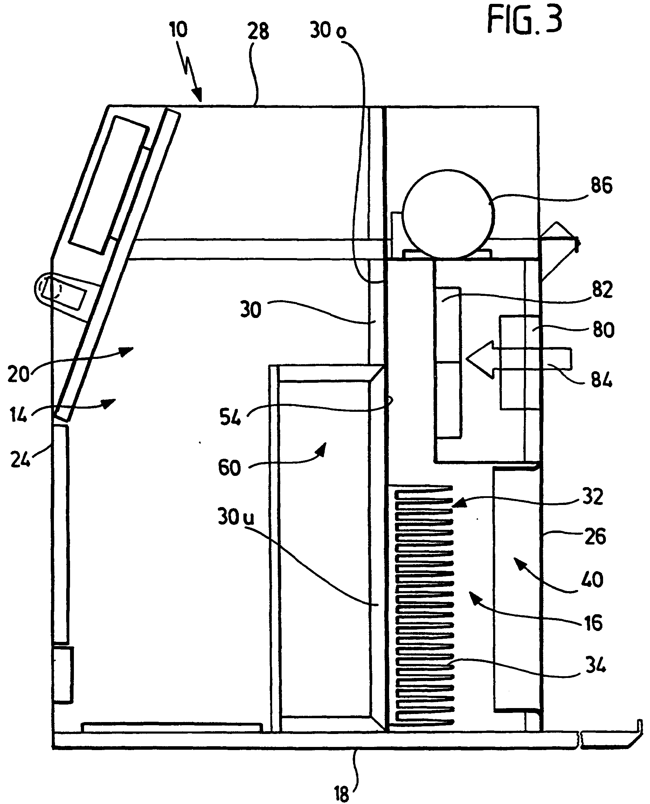

Bei einem zweiten Ausführungsbeispiel einer erfindungsgemäßen Stromversorgungseinheit, dargestellt in Figur 3, sind diejenigen Teile, die mit den des ersten Ausführungsbeispiels identisch sind, mit denselben Bezugszeichen versehen, so daß hinsichtlich der Beschreibung derselben vollinhaltlich auf die Ausführungen zum ersten Ausführungsbeispiel Bezug genommen wird.

Im Gegensatz zum ersten Ausführungsbeispiel sind in dem Kühlraum 16 nicht nur der Kühlkörper 32 mit seinen Kühlrippen 34 sowie das Gebläse 40 angeordnet, sondern es ist zusätzlich, beispielsweise über dem Kühlkörper 32 und dem Gebläse 40, ein weiteres Gebläse 80 vorgesehen, welches einen einen Wasserkühler 82 beaufschlagenden Luftstrom 84 erzeugt, wobei der Wasserkühler 82 dazu dient, Kühlwasser eines Kühlkreislaufs für eine Schweißeinheit zu kühlen.

Über dem Wasserkühler 82 und dem Gebläse 80 ist noch eine Umwälzpumpe 86 vorgesehen, welche dazu dient, das Kühlwasser des Kühlwasserkreislaufs umzuwälzen.

Ferner erstreckt sich bei dem zweiten Ausführungsbeispiel der Teilraum 60 nicht mehr über die gesamte Höhe des Außengehäuses 10 von der Bodenplatte 18 bis zum Deckel 28, sondern ausgehend von der Bodenplatte 18 nur über einen Teil der Trennwand 30.

Aus diesem Grund ist vorzugsweise die Trennwand 30 geteilt ausgebildet, nämlich in Form eines unteren Teils 30u und eines oberen Teils 30o. Der untere Teil 30u ist genau wie beim ersten Ausführungsbeispiel mit dem Durchbruch 64 versehen und erstreckt sich ausgehend von der Bodenplatte 18 im wesentlichen bis über die Höhe des Teilraums 60.

Zum Auswechseln der Leistungselektronik ist in diesem Fall der untere Teil 30u der Trennwand 30, der auch den Kühlkörper 30 trägt, als Ganzes entnehmbar, mitsamt der fest sowohl mit dem Kühlkörper 32 als auch mit dem Teil 30u verbundenen Leistungselektronik, die somit ebenfalls als komplette Einheit austauschbar ist.

Bei dem zweiten Ausführungsbeispiel gemäß Figur 3 ist der gesamte, den Kühlraum 16 übergreifende Bereich der Seitenwand 20 als lösbare oder abnehmbare Abdeckung 52 ausgebildet, so daß nach Abnehmen derselben, wie in Figur 3 dargestellt, der gesamte Kühlraum 16 von der Seite her zugänglich ist.

## Patentansprüche

1. Stromversorgungseinheit für Schweißgeräte, umfassend ein Außengehäuse, welches einen Schaltungsraum umgibt, in welchem elektrische Bauteile einer Stromversorgungsschaltung angeordnet sind, und einen Kühlkörper mit von einem zwangsbewegten Luftstrom angeströmten Kühlrippen, welche Abwärme von wärmeentwickelnden elektrischen Bauteilen der Stromversorgungsschaltung an den zwangsbewegten Luftstrom abgeben, dadurch gekennzeichnet, daß das Außengehäuse (12) neben dem Schaltungsraum (14) ein von diesem getrennten Kühlraum (16) umgibt, daß die Kühlrippen (34) des Kühlkörpers (32) im den Kühlraum (16) angeordnet sind und daß das Außengehäuse (12) mindestens eine Seitenwand des Kühlraums (16) bildet.

2. Stromversorgungseinheit nach Anspruch 1, dadurch gekennzeichnet, daß das Außengehäuse (12) in seinem die Seitenwand des Kühlraums (16) bildenden Bereich eine mit einer lösbaren Abdeckung (52) verschließbare Reinigungsöffnung (54) aufweist, durch welche der Kühlraum (16) zugänglich ist.

3. Stromversorgungseinheit nach Anspruch 2, dadurch gekennzeichnet, daß der Schaltungsraum (14) durch die Reinigungsöffnung (54) unzugänglich angeordnet ist.

4. Stromversorgungseinheit nach Anspruch 2 oder 3, dadurch gekennzeichnet, daß die Reinigungsöffnung (54) außerhalb von an den Schaltungsraum (14) angrenzenden Bereichen des Außengehäuses (12) angeordnet ist.

5. Stromversorgungseinheit nach einem der voranstehenden Ansprüche, dadurch gekennzeichnet, daß das Außengehäuse (12) in den Seitenwände des Kühlraums (16) bildenden Bereichen Auslaßöffnungen (50) für einen Abluftstrom (48) aufweist.

6. Stromversorgungseinheit nach Anspruch 5, dadurch gekennzeichnet, daß die lösbare Abdeckung (52) der Reinigungsöffnung (54) mit den Auslaßöffnungen (50) für den Abluftstrom (48) versehen ist.

7. Stromversorgungseinheit nach einem der voranstehenden Ansprüche, dadurch gekennzeichnet, daß das Außengehäuse (12) mindestens zwei Seitenwände des Kühlraums (16) bildet.

8. Stromversorgungseinheit nach Anspruch 7, dadurch gekennzeichnet, daß das Außengehäuse (12) mindestens drei Seitenwände des Kühlraums (16) bildet.

9. Stromversorgungseinheit nach Anspruch 7 oder 8, dadurch gekennzeichnet, daß das Außengehäuse (12) zwei einander gegenüberliegende Reinigungsöffnungen (54) aufweist.

10. Stromversorgungseinheit nach einem der voranstehenden Ansprüche, dadurch gekennzeichnet, daß der Kühlraum (16) und der Schaltungsraum (14) im Außengehäuse (12) auf gegenüberliegenden Seiten angeordnet sind.

11. Stromversorgungseinheit nach einem der voranstehenden Ansprüche, dadurch gekennzeichnet, daß der Kühlraum (16) und der Schaltungsraum (14) auf gegenüberliegenden Seiten einer Trennwand (30) angeordnet sind.

12. Stromversorgungseinheit nach Anspruch 11, dadurch gekennzeichnet, daß ein vom Außengehäuse (12) umschlossener Innenraum durch die Trennwand (30) in den Schaltungsraum (14) und den Kühlraum (16) aufgeteilt ist.

13. Stromversorgungseinheit nach einem der voranstehenden Ansprüche, dadurch gekennzeichnet, daß der Schaltungsraum (14) und der Kühlraum (16) hermetisch voneinander getrennt sind.

14. Stromversorgungseinheit nach einem der voranstehenden Ansprüche, dadurch gekennzeichnet, daß der Kühlraum (16) frei von elektrischen Bauteilen der Stromversorgungsschaltung ist.

15. Stromversorgungseinheit nach einem der voranstehenden Ansprüche, dadurch gekennzeichnet, daß der Kühlraum (16) frei von elektrischen Leitungen der Stromversorgungsschaltung ist.

16. Stromversorgungseinheit nach einem der Ansprüche 11 bis 15, dadurch gekennzeichnet, daß der Kühlkörper (32) an der Trennwand (30) angeordnet ist.

17. Stromversorgungseinheit nach Anspruch 16, dadurch gekennzeichnet, daß die Trennwand (30) einen Durchbruch (64) aufweist und daß im Bereich des Durchbruchs (64) der Kühlkörper (32) einen Teil der Trennwand (30) bildet.

18. Stromversorgungseinheit nach Anspruch 16 oder 17, dadurch gekennzeichnet, daß die wärmeentwickelnden Bauteile (62, 74) in Kontakt mit einer dem Schaltungsraum (14) zugewandten Seite (70, 72) des Kühlkörpers (32) stehen.

19. Stromversorgungseinheit nach einem der Ansprüche 11 bis 18, dadurch gekennzeichnet, daß zwischen dem Kühlkörper (32) und der Trennwand (30) eine Abdichtung angeordnet ist.

20. Stromversorgungseinheit nach einem der Ansprüche 11 bis 19, dadurch gekennzeichnet, daß der Kühlkörper (32) mit einer die Kühlrippen (34) tragenden Grundplatte (44) versehen ist.

21. Stromversorgungseinheit nach Anspruch 20, dadurch gekennzeichnet, daß der Kühlkörper (32) auf seiner den Kühlrippen (34) abgewandten Seite der Grundplatte (44) mit Anschlußelementen (70, 72) für die wärmeentwickelnden Bauteile (62, 74) versehen ist.

22. Stromversorgungseinheit nach einem der voranstehenden Ansprüche, dadurch gekennzeichnet, daß die Kühlrippen (34) des Kühlkörpers (32) in einer Richtung (42) quer zu der Grundplatte (44) vom Luftstrom (36) angeströmt sind.

23. Stromversorgungseinheit nach Anspruch 22, dadurch gekennzeichnet, daß der Kühlkörper (32) mit einem frontal auf die Grundplatte (44) gerichteten Luftstrom (36) angeströmt ist.

24. Stromversorgungseinheit nach einem der voranstehenden Ansprüche, dadurch gekennzeichnet, daß eine parallel zu den Kühlrippen (34) verlaufende Austrittsrichtung (46) des Luftstroms (36) in Richtung der Reinigungsöffnung (54) weist.

25. Stromversorgungseinheit nach einem der voranstehenden Ansprüche, dadurch gekennzeichnet, daß der Luftstrom (36) zwei entgegengesetzte und sich parallel zu den Kühlrippen (34) ausbreitende Abluftströme (48) bildet, die sich in Richtung der einander gegenüberliegenden Reinigungsöffnungen (54) ausbreiten.

26. Stromversorgungseinheit nach einem der voranstehenden Ansprüche, dadurch gekennzeichnet, daß in dem Kühlraum (16) ein Gebläse (40) zur Erzeugung des zwangsbewegten Luftstroms (36) angeordnet ist.

27. Stromversorgungseinheit nach einem der voranstehenden Ansprüche, dadurch gekennzeichnet, daß in dem Kühlraum (16) ein Wasserkühler (82) für einen Kühlwasserkreislauf einer Schweißeinrichtung angeordnet ist.

28. Stromversorgungseinheit nach Anspruch 27, dadurch gekennzeichnet, daß der Wasserkühler (82) von einem zwangsbewegten Luftstrom (84) angeströmt ist.

29. Stromversorgungseinheit nach Anspruch 26, dadurch gekennzeichnet, daß dem Wasserkühler (82) ein Gebläse (84) zugeordnet ist.

30. Stromversorgungseinheit nach einem der voranstehenden Ansprüche, dadurch gekennzeichnet, daß die gesamte Leistungselektronik mit dem Kühlkörper (32) verbunden und als Einheit mit diesem demontierbar ist.

31. Stromversorgungseinheit nach Anspruch 30, dadurch gekennzeichnet, daß die mit dem Kühlkörper (32) verbundene Leistungselektronik über den Kühlraum (16) zusammen mit dem Kühlkörper (32) demontierbar ist.
